# EUROPÄISCHE PATENTSCHRIFT

(11) **EP 2 184 959 B1**
(45) Veröffentlichungstag und Bekanntmachung des Hinweises auf die Patenterteilung: **06.03.2019**
(21) Anmeldenummer: 09013776.1
(22) Anmeldetag: 03.11.2009
(51) Int. Cl.: H05K 3/30, H05K 3/32, H05K 3/34

(54) **Leiterplatte zur Bestückung mit oberflächenmontierbaren und drahtgebundenen Bauteilen und Verfahren zur Herstellung einer Leiterplatte**
Circuit board for assembly with surface-mounted and leaded components and method for producing a circuit board
Circuit imprimé destiné au montage de composants pouvant être montés en surface et de composants reliés par un fil et procédé de fabrication de ce circuit imprimé

(30) Priorität: 11.11.2008 DE 102008056826
(43) Veröffentlichungstag der Anmeldung: 12.05.2010
(73) Patentinhaber: Neuschäfer Elektronik GmbH, 35066 Frankenberg (DE)
(72) Erfinder: Neuschäfer, Wilfried, 35066 Frankenberg (DE)
(74) Vertreter: Patentanwälte Olbricht Buchhold Keulertz

(56) Entgegenhaltungen:
- WO-A1-2005/032224
- DE-A1- 4 418 016
- DE-A1-102004 020 897
- DE-A1-102005 045 161
- FR-A1- 2 854 761
- US-A- 4 628 598
- US-A- 5 581 875
- US-A1- 2006 037 778

## Beschreibung

Die Erfindung betrifft eine Leiterplatte zur Bestückung mit oberflächenmontierbaren und mit drahtgebundenen Bauteilen gemäß dem Oberbegriff von Anspruch 1, ein Verfahren zur Herstellung einer Leiterplatte gemäß Anspruch 14 sowie die Verwendung einer Leiterplatte gemäß Anspruch 22.

Die Mischbestückung von Leiterplatten mit SMDs (oberflächenmontierbare Bauteile = **S**urface **M**ounted **D**evice) und mit drahtgebundenen Bauteilen (THT = **T**hrough **H**ole **T**echnology) ist allgemein bekannt.

Ein großes Problem dabei ist jedoch, dass die Fertigung einer solchen mischbestückten Leiterplatte meist das manuelle Einsetzen der drahtgebundenen Bauteile erfordert. Der übliche Fertigungsablauf stellt sich beispielsweise wie folgt dar: Die Leiterplatte wird mit Lotpaste bedruckt, und maschinell mit SMDs bestückt. In einem ersten Lötschritt werden die SMDs per Reflow-Verfahren verlötet. Dann werden die drahtgebundenen Bauteile manuell eingesetzt und in einem zweiten Lötschritt durch Schwall- oder Wellenlöten verlötet. Insbesondere durch das manuelle Einsetzen der drahtgebundenen Bauteile und den zweiten Lötschritt ist diese Art der Mischbestückung jedoch sehr zeit- und kostenintensiv.

Um dem zu begegnen, wurden Leiterplatten entwickelt, mit denen es möglich ist, spezielle THT-Bauteile, nämlich Jumper, gleichzeitig mit den SMDs im ersten Lötschritt durch Reflow-Verfahren zu verlöten. DE 10 2004 063 135 A1 sieht dazu beispielsweise vor, dass abseits der Bestückungsflächen, nämlich in den Seitenflächen der Leiterplatte, metallisierte Öffnungen ausgebildet sind. In diese wird Lotpaste eingefüllt. Anschließend werden die Anschlusspins der Jumper eingesteckt, so dass die Anschlusspins beim Reflowlöten festgelegt werden.

Auf diese Weise können zwar SMDs und THT-Bauteile im gleichen Arbeitsschritt verlötet werden, dennoch ist - je nach Design des gewünschten Schaltkreises - immer noch ein zweiter Bestückungs- und Lötschritt für auf den Bestückungsseiten gewünschte bzw. essentielle THT-Bauteile notwendig.

DE 10 2005 045 161 A1 offenbart eine Leiterplatte zur gleichzeitigen Verlötung von SMDs und THT-Bauteilen mit dem Überkopf-Lötverfahren, wobei die metallisierten Anschlussbohrungen eine Verengung aufweisen, um die THT-Bauteile zu halten .

WO 2005/032224 A1 offenbart eine in eine Leiterplatte integrierte Haltevorrichtung in Form einer Zwischenschicht zur Verlötung von bedrahteten Bauteilen im Überkopf-Lötverfahren.

Ziel der Erfindung ist es, diese und weitere Nachteile des Standes der Technik zu überwinden und eine Leiterplatte zu entwickeln, die mit einfachen Mitteln kostengünstig herstellbar ist und die schnell und einfach mischbestückbar ist. Insbesondere sollen alle Bauteile in einem einzigen Reflow-Lötschritt verlötbar sein. Die Erfindung hat außerdem die Aufgabe ein Verfahren zur Herstellung einer solchen Leiterplatte zur Verfügung zu stellen, das rasch und bequem durchführbar ist.

Hauptmerkmale der Erfindung sind im kennzeichnenden Teil von Anspruch 1 und 14 angegeben. Ausgestaltungen sind Gegenstand der Ansprüche 2 bis 13 und 15 bis 22.

Bei einer Leiterplatte zur Bestückung mit oberflächenmontierbaren und mit drahtgebundenen Bauteilen, mit einer ersten Substratschicht, die auf ihrer Bestückungsseite eine Leiterbahnen aufweisende Leitschicht trägt und mit Durchgangsbohrungen versehen ist, mit einer zweiten Substratschicht, die eine Bestückungsseite aufweist und die mit Durchgangsbohrungen versehen ist, wobei die Durchgangsbohrungen eine Metallisierung aufweisen, und mit einer Zwischenschicht, die zwischen den Substratschichten angeordnet ist, sieht die Erfindung vor, dass die Durchgangsbohrungen in den Bestückungsseiten der Substratschichten ausgebildet sind und kongruent übereinander liegen, dass die metallisierten Durchgangsbohrungen elektrisch leitend mit den Leiterbahnen der Leitschicht der ersten Substratschicht verbunden sind und dass die Zwischenschicht zumindest abschnittsweise in die Durchgangsbohrung hineinragt.

Ein wesentlicher Vorteil der erfindungsgemäßen Leiterplatte besteht darin, dass die metallisierten Durchgangsbohrungen in den Bestückungsseiten der Substratschichten ausgebildet sind und kongruent übereinander liegen. Sie bilden mithin Stecklöcher für die Anschlußpins von THT-Bauteilen, die somit bequem an den Bestückungsseiten anbringbar sind. Zweckmäßig ragt dabei die Zwischenschicht zumindest abschnittsweise in die Durchgangsbohrung hinein, so dass die Anschlusspins beim Einführen in die Stecklöcher mechanisch fixiert werden. Die THT-Bauteile können dadurch nicht mehr aus den Stecklöchern herausfallen, wodurch die Leiterplatte besser handhabbar ist.

Günstig ist ferner, dass die Zwischenschicht aus einem elektrisch leitenden Material besteht. Dadurch kann ein direkter elektrischer Kontakt zwischen den Anschlusspins und der Metallisierung der Durchgangsbohrung hergestellt werden. Dabei ist es vorteilhaft, dass die metallisierten Durchgangsbohrungen elektrisch leitend mit den Leiterbahnen der Leitschicht der ersten Substratschicht verbunden sind.

Dadurch kann mit Hilfe der metallisierten Durchgangsbohrungen ein elektrisch leitender Kontakt zwischen den Leiterbahnen dieser Leitschicht, bzw. deren Baugruppen, und weiteren Bauteilen hergestellt werden. Insbesondere ist es möglich, zunächst die Bestückungsseite der ersten Substratschicht mit Lotpaste zu bedrucken, wobei die Lotpaste die Durchgangsbohrungen bedeckt. Anschließend wird die bedruckte Bestückungsseite mit SMDs bestückt, die elektrisch leitend mit den metallisierten Durchgangsbohrungen verbunden sind und - sofern die Zwischenschicht elektrisch leitend ist - auch mit dieser. Die Bestückungsseite der zweiten Substratschicht kann nun mit drahtgebundenen Bauteilen (THT-Bauteilen) bestückt werden, die derart angeordnet sind, dass ihre Anschlusspins die Zwischenschicht von der nicht mit Lotpaste bedruckten Seite her durchstoßen. Damit sind alle SMDs auf der Bestückungsseite der ersten Substratschicht angeordnet, während alle THT-Bauteile auf der Bestückungsseite der zweiten Substratschicht liegen, wobei die Anschlusspins bis in die Lotpaste der bedruckten Seite hineinragen. Sobald alle Bauteile auf der Leiteplatte aufgebracht sind, kann die Leiterplatte in nur einem Arbeitsschritt verlötet werden.

Man erkennt, dass es günstig ist, wenn die Zwischenschicht im Bereich der Durchgangsbohrungen der Substratschichten mit Durchbrüchen versehen ist, wobei die Lichte Weite der Durchgangsbohrungen in der Zwischenschicht bevorzugt kleiner ist als der Durchmesser der Durchgangsbohrungen in den Substratschichten. Die Anschlusspins werden dadurch beim Einstecken in die Durchbrüche mechanisch fixiert. Die Bauteile können damit nicht mehr verrutschen oder von der Leiterplatte abfallen, wenn diese im anschließenden Lötverfahren gedreht werden sollte. Die Durchbrüche können unterschiedlichste Formen haben. So sind einfache Schlitze oder Kreuzschlitze vorstellbar, welche durch Stanzen, Prägen oder ähnliche Verfahren eingebracht werden. Denkbar sind aber auch Bohrungen, Fräsungen, Ätzungen o.dgl.

Günstig ist ferner, wenn die Lichte Weite der Durchbrüche der Zwischenschicht kleiner ist als der Außendurchmesser der Anschlusspins. Vorteilhaft können dann nämlich die drahtgebundenen Bauteile in der Zwischenschicht kraft- oder reibschlüssig gehalten sein. Die Bauteile können dann bei einer Anbringung auf der Unterseite nicht aus der Leiterplatte fallen. Dies ist insbesondere günstig, wenn man folgenden Fertigungsablauf betrachtet:
Zunächst wird die Bestückungsseite der ersten Substratschicht mit Lotpaste bedruckt und mit SMDs bestückt. Diese haften auf der Lotpaste. Danach wird die Leiterplatte umgedreht und die Bestückungsseite der zweiten Substratschicht wird mit THT-Bauteilen bestückt, indem die Anschlussdrähte in die dafür vorgesehenen Durchgangsbohrungen eingesteckt und durch die Zwischenschichten hindurch geschoben werden. Anschließend wird die bestückte Leiterplatte erneut umgedreht, so dass die mit Lotpaste bedruckte Bestückungsseite wieder oben liegt. Dann wird die Leiterplatte in einem einzigen Schritt im Reflow-Verfahren verlötet.

Weil die Lotpaste beim Reflow-Löten flüssig wird, es sinnvoll ist, die bestückte Leiterplatte mit der bedruckten Seite nach oben in den Lötofen zu geben. In dieser Stellung sind jedoch die THT-Bauteile an der Unterseite der Leiterplatte angeordnet. Durch die kraft- und/oder reibschlüssige Fixierung der Anschlusspins in der Zwischenschicht können die THT-Bauteile jedoch nicht aus der Leiterplatte herausfallen, die vielmehr in nur einem Arbeitsschritt zusammen mit den SMD-Bauteilen verlötet werden.

Ein weiterer Vorteil der erfindungsgemäßen Leiterplatte besteht darin, dass alle Bestückungsschritte maschinell durchführbar sind. Es können somit in erheblichem Umfang Kosten eingespart werden. Daneben ist nur noch ein einziger Lötschritt notwendig, um alle Bauteile mit der Leiterplatte zu verlöten. Dies spart nicht nur den vormals zweiten Lötschritt, sondern auch die mit diesem und der manuellen Bestückung einhergehenden Kontroll- und Dokumentationsschritte.

Mithin wird eine Leiterplatte zur Verfügung gestellt, die mit einfachen Mitteln, schnell und kostengünstig herstellbar ist und bei der die auf der Bestückungsseite der ersten Substratschicht angeordneten SMDs mit den auf der Bestückungsseite der zweiten Substratschicht angeordneten drahtgebundenen Bauelementen vorteilhaft einen gemeinsamen Schaltkreis bilden.

Im Sinne einer gewissen Stabilität der Leiterplatte ist es zweckmäßig, wenn die Substratschichten und die Zwischenschicht form-, kraft- und/oder stoffschlüssig miteinander verbunden sind. Dies stellt sicher, dass sich die Schichten nicht gegeneinander verschieben können, wodurch die Funktionstüchtigkeit der Leiterplatte unmittelbar beeinträchtigt würde.

Die Verbindung erfolgt sinnvollerweise, indem zwischen der Zwischenschicht und jeder Substratschicht eine Verbindungsschicht angeordnet ist, wobei die Durchgangsbohrungen der Substratschichten in den Verbindungsschichten fortgesetzt sind. Bei der Verbindungsschicht kann es sich zum Beispiel um eine Harz- oder Kleberschicht in Form einer Folie oder Platte handeln, andere Verbindungsmitteln und Formen sind aber auch denkbar.

In weiteren Ausführungsvarianten trägt die zweite Substratschicht auf ihrer Bestückungsseite eine Leiterbahnen aufweisende Leitschicht oder es ist zwischen den Substratschichten wenigstens eine weitere Substratschicht und/oder wenigstens eine weitere Zwischenschicht angeordnet ist, um die Leiterplatte mit drei oder mehr Substratschichten mehrschichtig auszubilden. Zwischen zwei benachbarten Substratschichten ist jeweils eine Zwischenschicht ausgebildet, die innerhalb der Durchgangsbohrungen die drahtgebundenen Bauteile sichert und Kontaktiert.

Diese Varianten, die selbstverständlich auch kombiniert vorliegen können, ermöglichen das Design komplexer Schaltkreise. Dabei können die Leiterbahnen in verschiedenen Ebenen angeordnet sein - beispielsweise auch in der Zwischenschicht - welche mit Hilfe der metallisierten Durchgangsbohrungen miteinander auf unterschiedlichste Weise verknüpft sein können. Mithin ist es von Vorteil, wenn die Metallisierung der Durchgangsbohrungen die Zwischenschichten mit den Leiterschichten durch die Substratschichten hindurch elektrisch leitend verbindet.

Neben der erfindungsgemäßen Leiterplatte sieht die Erfindung ein Verfahren zur Herstellung einer solchen Leiterplatte vor, umfassend die Schritte
▪ Bereitstellung einer ersten und einer zweiten Substratschicht;
▪ Einbringen von Durchgangsbohrungen in die Substratschichten;
▪ Auflegen einer Zwischenschicht aus einem elektrisch leitendem Material auf die der Bestückungsseite abgewandten Seite der erste Substratschicht;
▪ Auflegen der zweiten Substratschicht mit ihrer Bestückungsseite abgewandten Seite auf die Zwischenschicht;
▪ form-, kraft- und/oder stoffschlüssiges Verbinden aller Schichten miteinander;
▪ Einbringen von Durchbrüchen in die Zwischenschicht im Bereich der Durchgangsbohrungen;
▪ Reinigung der Durchgangsbohrungen;
▪ Metallisierung der Durchgangsbohrungen; und
▪ Strukturierung der Bestückungsseiten der Leiterplatte, wobei
die Zwischenschicht vor dem Auflegen der zweiten Substratschicht bzw. der zweiten Verbindungsschicht zu einer mittleren Signalebene mit Leiterbahnen strukturiert wird.

Dieses Verfahren zeichnet sich insbesondere durch seine einfache, schnelle und kostengünstige Durchführbarkeit aus. Es ist leicht in Bezug auf die jeweilige gewünschte spezielle herzustellende Leiterplatte anpassbar. So kann einerseits die Anordnung der Durchbohrungen individuell verändert werden. Es ist aber auch vorstellbar, dass die Anordnung der Durchgangsbohrungen entsprechend einem stets konstanten Raster vorgenommen wird und bei der Strukturierung der Bestückungsseiten der Leiterplatte unterschiedliche Verknüpfungen der Durchgangsbohrungen hergestellt werden. Auch ist denkbar, dass vor dem Verpressen weitere Substrat- und Zwischenschichten aufgelegt werden und so weitere Signalebenen in der Leiterplatte erhalten werden können.

Ein weiterer Vorteil des Verfahrens besteht darin, dass die Durchbrüche in der Zwischenschicht nach dem Verpressen der Schichten eingebracht werden. Somit wird ein weiterer Ausrichtungsschritt, welcher gegebenenfalls nötig ist um alle entsprechenden Durchbohrungen kongruent übereinander anzuordnen, beim Auflegen der Zwischenschicht gespart. Darüber hinaus können sehr dünne Materialien für die Zwischenschicht verwendet werden, bei denen ansonsten beispielsweise die Gefahr des Einreißens bestünde.

Günstig ist auch, wenn die Strukturierung der Bestückungsseiten der Leiterplatte zum Schluss vorgenommen wird. Sie kann dann wie bei einer herkömmlichen einschichtigen Leiterplatte beispielsweise durch klassische galvanische Metallisierung erfolgen. Denkbar ist aber auch eine vollflächige galvanische Metallisierung gefolgt von einer Strukturierung durch Ätzen. Außerdem ist die Strukturierung durch Lasertechniken oder ähnliches denkbar.

Zur Sicherstellung der Stabilität der Leiterplatte, sieht das Verfahren vor, dass zwischen der ersten Substratschicht und der Zwischenschicht eine erste Verbindungsschicht angeordnet wird. Dabei kann es außerdem sinnvoll sein, dass zwischen der Zwischenschicht und der zweiten Substratschicht eine zweite Verbindungsschicht angeordnet wird. Vorteilhaft ist es in jedem Fall, wenn in jeder Verbindungsschicht Bohrungen eingebracht werden, die beim Aufeinanderlegen der Verbindungs- und Substratschichten deckungsgleich mit den Durchgangsbohrungen der Substratschichten angeordnet sind. Dies erleichtert das Nachbearbeiten der Leiterplatte. So wird zwar beim Verpressen der Schichten miteinander ein Teil des Materials der Verbindungsschicht, beispielsweise Harz- oder ein andere Kleber, in den Bereich der Durchbohrung gepresst. Der Anteil dieses Materials ist jedoch im Verhältnis relativ gering, wenn zuvor die Bohrungen in die Verbindungsschicht eingebracht wurden.

Zur Entfernung des überschüssigen Klebers aus den Durchgangsbohrungen ist bevorzugt vorgesehen, dass das Reinigen und Metallisieren der Bohrungen die folgenden Schritte umfasst
▪ Reinigen der Leiterplatte mittels Rückätzlösung;
▪ Einbringung von kapillaren Ausnehmungen an den Stellen, an denen die Zwischenschicht in die Durchgangsbohrung eintritt, mittels Rückätzlösung;
▪ Eintauchen der Leiterplatte in eine Metallisierungslösung; und
▪ Einbringen der Leiterplatte in ein Hochvakuum.

Dabei ist es wichtig, den Teil der Zwischenschicht, welcher in die Durchgangsbohrung hineinragt gut von allen Resten der Verbindungsschicht zu reinigen, da ansonsten die Metallisierungslösung keinen ausreichenden Kontakt zur Zwischenschicht herstellen könnte.

Das erfindungsgemäße Verfahren sieht daher vor, in dem Bereich, in welchem die Zwischenschicht in die Durchgangsbohrungen eintritt, mit Hilfe der Rückätzlösung kapillare Ausnehmungen einzubringen. Diese können sowohl die Verbindungsschichten als auch die Substratschichten erfassen. In der Folge werden diese Ausnehmungen mit Metallisierungslösung gefüllt, wobei die Metallisierung die Zwischenschicht in dem kritischen Bereich besonders gut umhüllt, wodurch eine zuverlässige Kontaktherstellung gesichert ist.

Besonders vorteilhaft ist es dabei, wenn die Leiterplatte nach der Einbringung der Ausnehmungen in Metallisierungslösung getaucht und in ein Hochvakuum eingebracht wird. Im Hochvakuum kann die Metallisierungslösung nämlich allein durch Kapillarkräfte in die Ausnehmungen eindringen und diese vollständig ausfüllen.

Auf gleiche Weise kann verfahren werden, um im Anschluss eine Galvanisierungslösung optimal in den Durchgangsbohrungen zu verteilen. Die metallisierten Leiterplatten werden dann in die Galvanisierungslösung getaucht und erneut in ein Hochvakuum eingebracht.

Das Erfindungsgemäße Verfahren sieht weiterhin vor, dass die Zwischenschicht, die erste Verbindungsschicht und die erste Substratschicht nach dem Auflegen der Zwischenschicht auf die erste Verbindungsschicht miteinander verpresst werden kann. Dies ist insbesondere dann sinnvoll, wenn die Zwischenschicht vor dem Auflegen der zweiten Substrat- bzw. der zweiten Verbindungsschicht strukturiert wird.

Die Strukturierung der Zwischenschicht dient dazu eine mittlere Signalebene mit Leiterbahnen herzustellen.

Man erkennt insgesamt, dass es von besonderem Vorteil ist, die erfindungsgemäßen Leiterplatte zur Herstellung einer mischbestückten Leiterplatte zu verwenden. Letztere kann dadurch auf raschem, kostengünstigem und einfachem Wege bereitgestellt werden. Insbesondere können dabei sowohl oberflächenmontierbare als auch drahtgebundene Bauteile maschinell bestückt werden und es ist nur ein Lötschritt erforderlich.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1a: Eine Ausführungsvariante der erfindungsgemäßen Leiterplatte mit zwei Substratschichten,
- Fig. 1b: Detailansicht einer mit SMDs und THT-Bauteilen bestückten Leiterplatte,
- Fig. 2: Eine weitere Ausführungsvariante der erfindungsgemäßen Leiterplatte mit mehreren Substrat- und Zwischenschichten,
- Fig. 3: Detailansicht einer metallisierten Durchbohrung,
- Fig. 4a bis 4g: Ablauf einer Mischbestückung einer erfindungsgemäßen Leiterplatte und
- Fig. 5a bis 5h: Fertigungsstufen einer erfindungsgemäßen Leiterplatte bei der Herstellung mit Hilfe des erfindungsgemäßen Verfahrens.

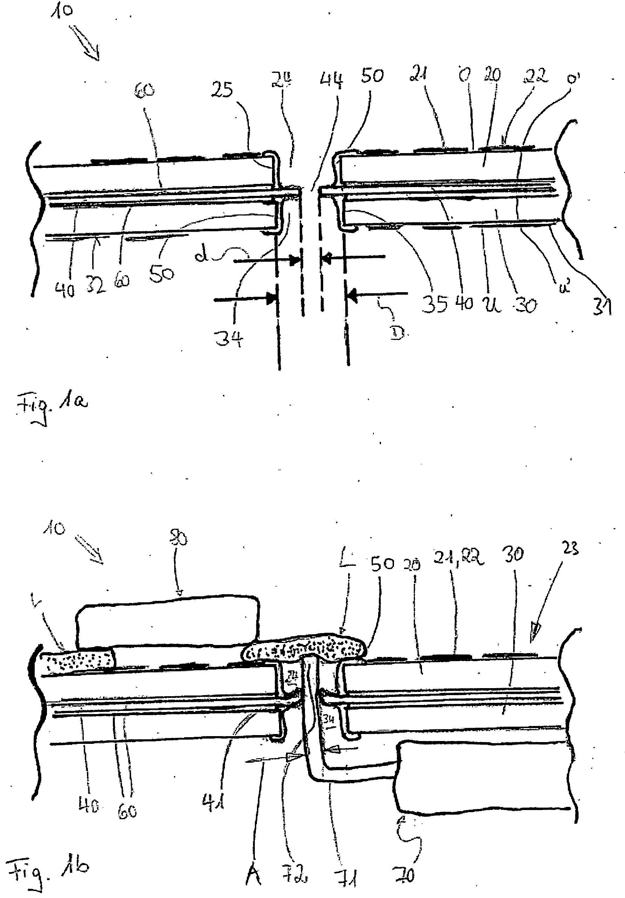

Die in Fig. 1a gezeigte Leiterplatte 10 besteht aus einer ersten Substratschicht 20 mit einer Bestückungsseite O, einer Zwischenschicht 40 und einer zweiten Substratschicht 30 mit einer Bestückungsseite U. Um die Zwischenschicht 40 mit der ersten und der zweiten Substratschicht 20, 30 zu verbinden ist zwischen der ersten Substratschicht 20 und der Zwischenschicht 40 bzw. zwischen der zweiten Substratschicht 30 und der Zwischenschicht 40 jeweils eine Verbindungsschicht 60 angeordnet. Genauer gesagt ist eine Verbindungsschicht 60 zwischen der Zwischenschicht 40 und der der Bestückungsseite O der ersten Substratschicht 20 abgewandten Seite o' angeordnet und eine weitere Verbindungsschicht 60 zwischen der Zwischenschicht 40 und der der Bestückungsseite U der zweiten Substratschicht 30 abgewandten Seite u'. Bei den Verbindungsschichten 60 kann es sich beispielsweise um ein Harz oder einen Klebstoff handeln.

Sowohl in der ersten Substratschicht 20, als auch in der zweiten Substratschicht 30 ist jeweils eine Durchgangsbohrung 24, 34 ausgebildet. Man erkennt, dass die Durchgangsbohrungen 24, 34 beide den Durchmesser D haben und kongruent übereinander angeordnet sind. Auch in der Zwischenschicht 40 ist ein Durchbruch 44 ausgebildet. Die Lichte Weite d des Durchbruchs 44 ist jedoch kleiner als der Durchmesser D der Durchgangsbohrungen 24, 34. Mithin ragt die Zwischenschicht 40 mit einem Teil 41 in die Durchgangsbohrungen 24, 34 hinein.

Man erkennt weiterhin, dass die Innenwände 25, 35 der Durchgangsbohrungen 24, 34 eine durchgängige Metallisierung 50 aufweisen. Diese stellt einen elektrisch leitenden Kontakt zwischen der Zwischenschicht 40 und Leiterbahnen 22 einer Leitschicht 21 her, welche auf der Bestückungsseite O der ersten Substratschicht 20 ausgebildet sind. Mithin verfügt die dargestellte Leiterplatte 10 über mindestens eine Signalebene 23. Weitere Signalebenen 23' können beispielsweise an der Bestückungsseite U der zweiten Substratschicht 30 oder in der Zwischenschicht 40 ausgebildet sein. Mit Hilfe der Metallisierung 50 können die Signalebenen 23, 23' miteinander verbunden werden.

In Fig. 1b ist die Bestückungsseite O der Leiterplatte 10 aus Fig. 1a mit Lotpaste L bedruckt. Diese bedeckt auch die Durchgangsbohrung 24 und ist in Kontakt mit der Metallisierung 50. Die bedruckte Bestückungsseite O ist außerdem mit SMD-Bauteilen 80 bestückt.

Die Bestückungsseite U der zweiten Substratschicht 30 ist dagegen mit drahtgebundenen Bauteilen 70 bestückt. Diese haben Anschlusspins 71, deren Enden 72 in die Durchgangsbohrung 24, 34 gesteckt sind. Man erkennt, dass der Außendurchmesser A des Endes 72 größer ist als die Lichte Weite d des Durchbruchs 44 in der Zwischenschicht 40. Beim Einstecken des Endes 42 in den Durchbruch 44 wird daher der in die Durchgangsbohrung 24, 34 ragende Teil 41 der Zwischenschicht 40 in Richtung der Bestückungsseite O der ersten Substratschicht 20 gebogen (siehe Fig. 1b). Das Ende 72 des Anschlusspins 71 ist so weit in die Durchgangsbohrung 24, 34 gesteckt, dass des mit der Lotpaste L auf der Bestückungsseite O in Kontakt steht.

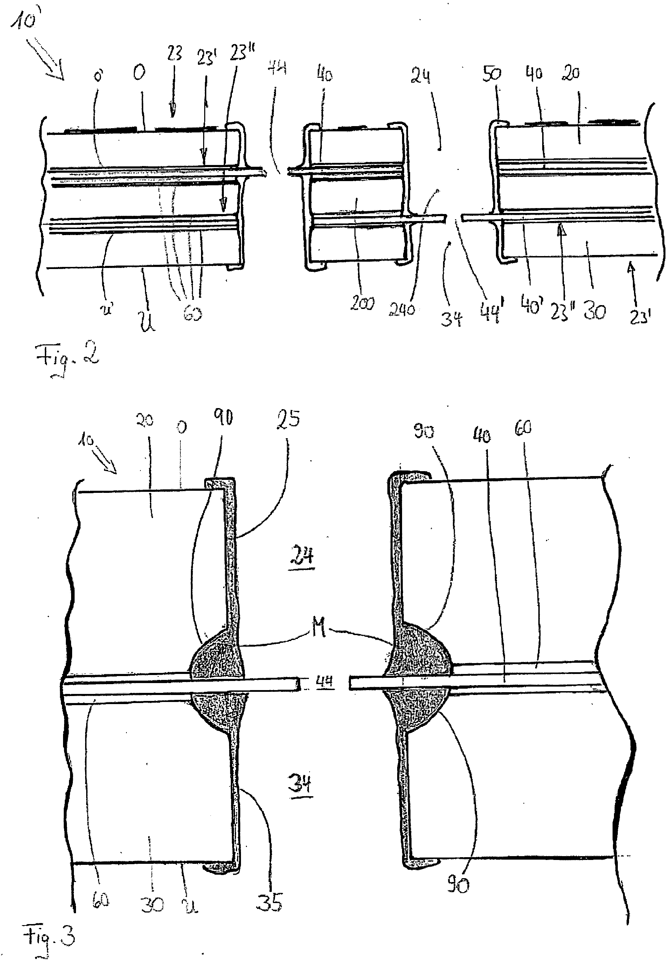

Bei einer weiteren - in Fig. 2 gezeigten - Ausführungsvariante einer Leiterplatte 10' sind zwischen der Zwischenschicht 40 und der zweiten Substratschicht 30 eine weitere Substratschicht 200 und eine weitere Zwischenschicht 40', sowie entsprechende Verbindungsschichten 60 angeordnet. Man sieht, dass in der weiteren Substratschicht 200 ebenfalls Durchgangsbohrungen 240 ausgebildet sind, die kongruent mit den Durchgangsbohrungen 24, 34 der ersten und der zweiten Substratschicht 20, 30 angeordnet sind. In der weiteren Zwischenschicht 40' sind ebenfalls Durchbrüche 44' ausgebildet.

Bei diesem Ausführungsbeispiel kann die weitere Zwischenschicht 40' - wie auch die Zwischenschicht 40 - vorteilhaft eine weitere Signalebene 23" bilden. Mit Hilfe der Metallisierung 50 können dann wiederum alle Zwischenschichten 40, 40' und Bestückungsseiten O, U miteinander elektrisch leitend verknüpft werden.

Man erkennt, dass die in die Durchgangsbohrungen 24, 240, 34 hineinragenden Teile 41, 41' der Zwischenschichten 40, 40' auch im Bereich ausgewählter Durchgangsbohrungen 24, 240, 34 entfernt werden können. Dies ist insbesondere dann von Vorteil, wenn unterschiedliche Signalebenen 23, 23', 23" durch unterschiedliche Metallisierungen 50, 50' miteinander verknüpft werden sollen. Die Entfernung der Teile 41, 41' kann dabei beispielsweise während der Strukturierung der Zwischenschichten 40, 40' erfolgen.

Um die Funktionsfähigkeit der Leiterplatte 10, 10' sicherzustellen, ist es besonders wichtig, dass die Metallisierung 50 die in die Durchgangsbohrungen 24, 34 hineinragenden Teile 41 der Zwischenschicht 40 ohne Luftblasen umschließt. Fig. 3 zeigt daher im Detail einen solchen Kontaktbereich.

Man erkennt, dass in die Substratschichten 20, 30 und in die Verbindungsschichten 60 jeweils eine Ausnehmung 90 eingebracht ist. Wird die Leiterplatte 10 nun in eine Metallisierungslösung M getaucht und anschließend in ein Hochvakuum eingebracht, so kann die Metallisierungslösung M die Ausnehmungen 90 durch das Wirken von Kapillarkräften Luftblasenfrei ausfüllen. Auf gleiche Weise kann in der Folge eine Galvanisierungslösung aufgebracht werden.

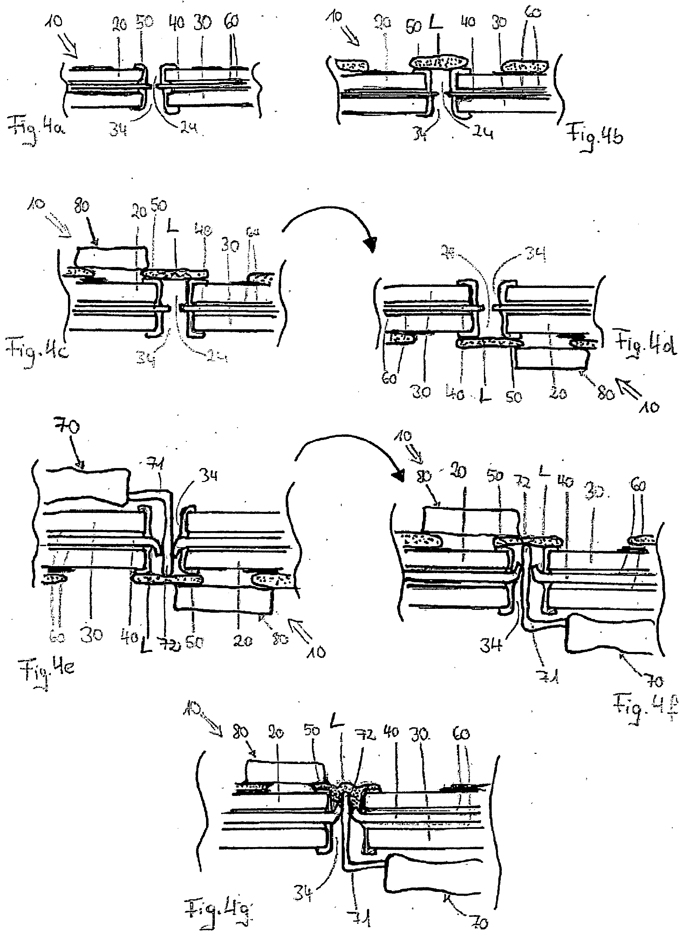

Bei dem in den Figuren 4a bis 4g gezeigten Bestückungsablauf wird zunächst eine erfindungsgemäße Leiterplatte 10 entsprechend einer der gezeigten Ausführungsvarianten bereitgestellt (Fig. 4a).

Dann wird die Bestückungsseite O der ersten Substratschicht 20 mit Lotpaste L bedruckt (Fig. 4b). Die Lotpaste L bedeckt dabei die Durchgangsbohrung 24 und ist in Kontakt mit der Metallisierung 50.

Als nächstes wird die Bestückungsseite O der ersten Substratschicht 20 mit SMDs 80 bestückt. Dies kann mit Hilfe eines herkömmlichen SMD-Bestückungsautomaten erfolgen. Die SMDs 80 bleiben vorteilhaft an der Lotpaste L kleben (Fig. 4c).

Die mit Lostpaste L bedruckte und mit SMDs 80 bestückte Leiterplatte 10 wird umgedreht (Fig. 4d). Dabei bleiben die SMDs weiterhin an der Lotpaste L haften.

Nun erfolgt die Bestückung der Bestückungsseite U der zweiten Substratschicht 30 mit drahtgebundenen Bauteilen 70 (Fig. 4e). Man erkennt, dass die Anschlusspins 71 in die Durchgangsbohrungen 34, 24 gesteckt werden. Dabei biegen sie die in letztere hinragenden Teile 41 der Zwischenschicht 40 in Richtung der Bestückungsseite O der ersten Substratschicht 20. Das Ende 72 der Anschlusspins 71 kann bis in die Lotpaste L reichen. Man erkennt außerdem in Fig. 4e, dass auch die Bestückung der drahtgebundenen Bauteile 70 vorteilhaft maschinell erfolgen kann, da auf der zu bestückenden Fläche keine SMDs 80 vorhanden sind, auf welche Rücksicht genommen werden müsste.

Vor dem Reflowlöten der Bauteile mit der Leiterplatte 10 wird die Leiterplatte 10 wieder umgedreht (Fig. 4f). Die drahtgebundenen Bauteile befinden sich nun an der Unterseite der Leiterplatte 10. Sie können jedoch nicht herausfallen, weil sie in der Zwischenschicht 40 fixiert sind. Zwischen den Enden 72 der Anschlusspins 71 und den in Richtung der Bestückungsseite O der ersten Substratschicht 20 gebogenen Teile 41 der Zwischenschicht 40 bewirken nämlich Reibungskräfte das Festklemmen der Anschlusspins 71 in den Durchbrüchen 44.

Wie man in Fig. 4g sieht, sind die Enden 72 der Anschlusspins 71 nach dem Reflow-Löten mit der Metallisierung 50 verlötet. Mithin ist ein elektrisch leitender Kontakt zwischen der mit SMDs 80 bestückten Bestückungsseite O der ersten Substratschicht 20 und den an der Bestückungsseite U der zweiten Substratschicht 30 angeordneten drahtgebundenen Bauteile 70 entstanden. Man erkennt, dass die SMDs 80 und die drahtgebundenen Bauteile 70 einen gemeinsamen Schaltkreis bilden, wobei alle SMDs 80 auf der einen und alle drahtgebunden Bauteile 70 auf der anderen Bestückungsseite O,U der Leiterplatte 10 angeordnet sind.

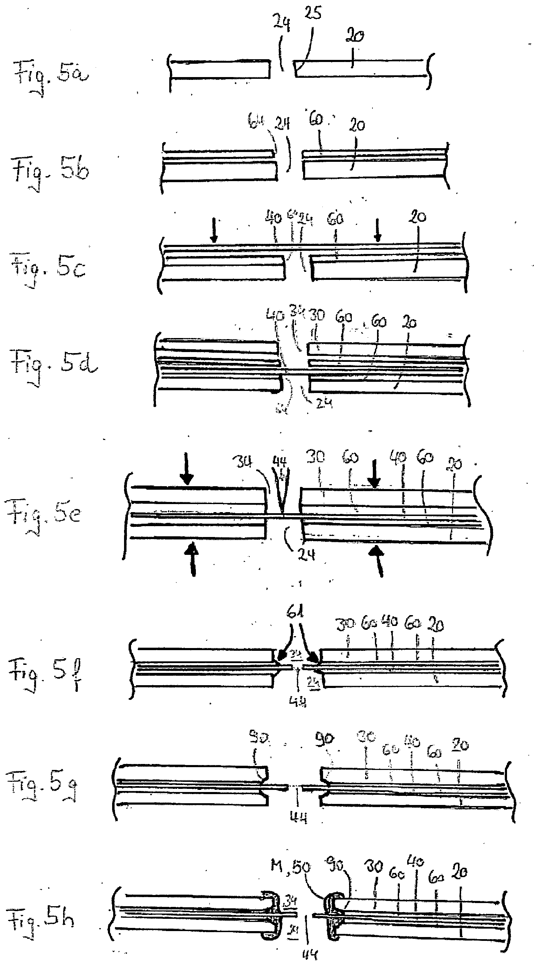

Der in den Figuren 5a bis 5h gezeigte schematische Ablauf eines Verfahrens zur Herstellung einer erfindungsgemäßen Leiterplatte beginnt mit der Bereitstellung der ersten Substratschicht 20, sowie mit der Einbringung der Durchgangsbohrungen 24 in diese (Fig. 5a).

Auf diese erste Substratschicht 20 wird eine erste Verbindungsschicht 60 aufgelegt (Fig. 5b). In dieser sind ebenfalls Durchgangsbohrungen 64 ausgebildet. Die Schichten werden so ausgerichtet, dass die Durchgangsbohrungen 24, 64 kongruent übereinander liegen.

Als nächstes wird auf die erste Verbindungsschicht 60 eine Zwischenschicht 40 aufgelegt. (Fig. 5c). Zweckmäßig können die drei Schichten mit einander vor-verpresst werden. Die Zwischenschicht 40 kann je nach Bedarf nun strukturiert werden. Dies kann durch verschiedenste gängige Methoden erfolgen, bspw. ätzen, lasern oder ähnliches.

Auf die Zwischenschicht 40 werden nun eine weitere Verbindungsschicht 60 und eine zweite Substratschicht 30 aufgelegt (Fig. 5d). Auch in diesen Schichten sind Durchgangsbohrungen 64, 34 ausgebildet, welche wiederum kongruent über den ersten Durchgangsbohrungen 24, 64 angeordnet werden. Je nach Bedarf, können weitere Zwischenschichten 40', Verbindungsschichten 60 und/oder Substratschichten 200 aufgelegt werden.

Sind alle Schichten wunschgemäß übereinander angeordnet, werden sie miteinander verpresst (Fig. 5e). In die Zwischenschichten 40 werden nun die Durchbrüche 44 eingebracht. Dies kann durch Stanzen, Bohren, Fräsen, Lasern oder ähnliche Techniken erfolgen, abhängig von der gewünschten Form und Größe des jeweiligen Durchbruchs 44.

Beim Verpressen wird Material 61 aus den Verbindungsschichten 60 in den Bereich der Durchgangsbohrungen 24, 34 gedrückt und haftet an der Zwischenschicht 40 (Fig. 5f). Um jedoch sicherzustellen, dass die Metallisierung 50 der Durchgangsbohrungen 24, 34 luftblasenfrei und im Vollständigen Kontakt mit der Zwischenschicht 40 hergestellt werden kann muss dieses Material 61 entfernt werden.

Dazu wird die Leiterplatte 10 mit Rückätzlösung behandelt (Fig. 5g). Auf diese Weise werden die kapillaren Ausnehmungen 90 eingebracht und die Leiterplatte 10 beispielsweise von unerwünschten Harz- oder Kleberresten befreit.

Zum Aufbringen der Metallisierung 50 wird die Leiterplatte 10 in eine Metallisierungslösung M getaucht und in ein Hochvakuum eingebracht. Durch die dort frei wirkenden Kapillarkräfte kann die Metallisierungslösung M die Ausnehmungen 90 vollständig ausfüllen (Fig. 5h). Auf die gleiche Art und Weise kann im Anschluss eine Galvanisierungslösung aufgebracht werden. Abschließend werden die nun außen liegenden Flächen der ersten und der zweiten Substratschicht 20, 30 strukturiert - bspw. durch vollflächige Galvanisierung und anschließendes Ätzen, oder aber durch klassische galvanische Metallisierung. Auf diese Weise entstehen die Bestückungsseiten O, U.

Die Erfindung ist nicht auf eine der vorbeschriebenen Ausführungsformen beschränkt, sondern in vielfältiger Weise abwandelbar. So ist es beispielsweise denkbar, die Durchbrüche 44 in der Zwischenschicht 40 vor dem Auflegen einzubringen, sofern ein entsprechend stabiles Material für die Zwischenschicht 40 verwendet wird.

Die Zwischenschicht 40 kann aus unterschiedlichen Materialien hergestellt werden, vorstellbar ist beispielsweise eine Kupfermembran oder verschiedene Legierungen.

Bei der Metallisierung 50 kann es sich auch um einfache Metallhülsen handeln, die in die Durchgangsbohrungen 24, 34 eingesetzt werden.

Vorstellbar ist auch, dass die Substratschichten 20, 30 und die Zwischenschicht 40 mit Hilfe von Befestigungsmitteln, beispielsweise Schrauben oder Schienen, mit einander verbunden werden.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

Man erkennt, dass eine Leiterplatte 10 zur Bestückung mit oberflächenmontierbaren und mit drahtgebundenen Bauteilen 80, 70 vorteilhaft mit einer ersten Substratschicht 20, die auf ihrer Bestückungsseite O eine Leiterbahnen 21 aufweisende Leitschicht 22 trägt und mit Durchgangsbohrungen 24 versehen ist, mit einer zweiten Substratschicht 30, die eine Bestückungsseite U aufweist und die mit Durchgangsbohrungen 34 versehen ist, wobei die Durchgangsbohrungen 24, 34 eine Metallisierung 50 aufweisen, und mit einer Zwischenschicht 40, die zwischen den Substratschichten 20, 30 angeordnet ist, ausgebildet ist, wobei die Durchgangsbohrungen 24, 34 in den Bestückungsseiten O, U der Substratschichten ausgebildet sind und kongruent übereinander liegen, wobei die metallisierten Durchgangsbohrungen 24, 34 elektrisch leitend mit den Leiterbahnen 21 der Leitschicht 22 der ersten Substratschicht verbunden sind, und wobei die Zwischenschicht 40 zumindest abschnittsweise in die Durchgangsbohrungen 24, 34 hineinragt.

Man erkennt weiterhin, dass die Zwischenschicht 40 vorteilhaft im Bereich der Durchgangsbohrungen 24, 34 der Substratschichten 20, 30 mit Durchbrüchen 44 versehen ist, wobei die Lichte Weite d der Durchgangsbohrungen 44 in der Zwischenschicht 40 kleiner ist als der Durchmesser D der Durchgangsbohrungen 24, 34 in den Substratschichten 20, 30. Günstigerweise sind dabei die drahtgebundenen Bauteile 70 in der Zwischenschicht 40 kraft- oder reibschlüssig gehalten und die an der Bestückungsseite O der ersten Substratschicht 20 angeordneten SMDs 80 bilden mit den an der Bestückungsseite U der zweiten Substratschicht 30 angeordneten drahtgebundenen Bauelementen 70 einen gemeinsamen Schaltkreis.

Mit Vorteil sind die Substratschichten 20, 30 und die Zwischenschicht 40 form-, kraft- und/oder stoffschlüssig miteinander verbunden, wobei zwischen der Zwischenschicht 40 und jeder Substratschicht 20, 30 eine Verbindungsschicht 60 angeordnet sein kann und wobei die Durchgangsbohrungen 24, 34 der Substratschichten 20, 30 in den Verbindungsschichten 60 fortgesetzt sind.

Die zweite Substratschicht 30 kann außerdem auf ihrer Bestückungsseite U eine Leiterbahnen aufweisende Leitschicht tragen und zwischen den Substratschichten 20, 30 kann wenigstens eine weitere Substratschicht 200 und/oder wenigstens eine weitere Zwischenschicht 40' angeordnet sein, wobei die Metallisierung 50 der Durchgangsbohrungen 24, 34 die Zwischenschichten 40, 40' mit den Leiterschichten 22 durch die Substratschichten 20, 30 hindurch elektrisch leitend verbindet.

Man erkannt weiter, dass ein Verfahren zur Herstellung einer erfindungsgemäßen Leiterplatte 10 die Schritte umfasst
▪ Bereitstellung einer ersten und einer zweiten Substratschicht 20, 30;
▪ Einbringen von Durchgangsbohrungen 24, 34 in die Substratschichten 20, 30;
▪ Auflegen einer Zwischenschicht 40 aus einem elektrisch leitendem Material auf die der Bestückungsseite O abgewandten Seite o' der erste Substratschicht 20;
▪ Auflegen der zweiten Substratschicht 30 mit ihrer Bestückungsseite U abgewandten Seite u' auf die Zwischenschicht 40;
▪ form-, kraft- und/oder stoffschlüssiges Verbinden aller Schichten miteinander;
▪ Einbringen von Durchbrüchen 44 in die Zwischenschicht 40 im Bereich der Durchgangsbohrungen 24, 34;
▪ Reinigung der Durchgangsbohrungen 24, 34;
▪ Metallisierung der Durchgangsbohrungen 24, 34; und
▪ Strukturierung der Bestückungsseiten O, U der Leiterplatte 10, wobei
   die Zwischenschicht (40) vor dem Auflegen der zweiten Substratschicht (30) bzw. der zweiten Verbindungsschicht (60) zu einer mittleren Signalebene mit Leiterbahnen strukturiert wird.

Dabei ist es zweckmäßig, wenn zwischen der ersten Substratschicht 20 und der Zwischenschicht 40 eine erste Verbindungsschicht 60 angeordnet wird und/oder dass zwischen der Zwischenschicht 40 und der zweiten Substratschicht 30 eine zweite Verbindungsschicht 60 angeordnet wird, wobei in jeder Verbindungsschicht 60 Bohrungen 64 eingebracht werden, die beim Aufeinanderlegen der Verbindungs- und Substratschichten 60, 20, 30 deckungsgleich mit den Durchgangsbohrungen 24, 34 der Substratschichten 20, 30 angeordnet sind. Vorteilhaft ist es außerdem, wenn das Reinigen und Metallisieren der Bohrungen die Schritte umfasst
▪ Reinigen der Leiterplatte 10 mittels Rückätzlösung;
▪ Einbringung von kapillaren Ausnehmungen 90 an den Stellen, an denen die Zwischenschicht 40 in die Durchgangsbohrungen 24, 34 eintritt, mittels Rückätzlösung;
▪ Eintauchen der Leiterplatte 10 in eine Metallisierungslösung M; und
▪ Einbringen der Leiterplatte 10 in ein Hochvakuum.

Die Zwischenschicht 40, die erste Verbindungsschicht 60 und die erste Substratschicht 20 können nach dem Auflegen der Zwischenschicht 40 auf die erste Verbindungsschicht 60 miteinander verpresst werden und die Zwischenschicht 40 kann vor dem Auflegen der zweiten Substratschicht 30 bzw. der zweiten Verbindungsschicht 60 strukturiert werden.

Die Erfindung ist nicht auf eine der vorbeschriebenen Ausführungsformen beschränkt, sondern in vielfältiger Weise abwandelbar. Man erkennt jedoch, dass eine Leiterplatte 10 zur Bestückung mit oberflächenmontierbaren (SMD) und mit drahtgebundenen Bauteilen 80, 70 eine erste Substratschicht aufweist, die auf ihrer Bestückungsseite O eine Leiterbahnen 21 aufweisende Leitschicht 22 trägt und mit Durchgangsbohrungen 24 versehen ist. Eine zweite Substratschicht 30 weist eine Bestückungsseite U auf und ist mit Durchgangsbohrungen 34 versehen, wobei die Durchgangsbohrungen 24, 34 eine Metallisierung 50 aufweisen. Zwischen den Substratschichten 20, 30 ist eine Zwischenschicht 40 angeordnet. Die Durchgangsbohrungen 24, 34 sind kongruent übereinander liegend in den Bestückungsseiten O, U der Substratschichten ausgebildet, wobei die metallisierten Durchgangsbohrungen 24, 34 elektrisch leitend mit den Leiterbahnen 21 der Leitschicht 22 der ersten Substratschicht verbunden sind. Die Zwischenschicht 40 ragt ferner zumindest abschnittsweise in die Durchgangsbohrungen 24, 34 hinein und ist im Bereich der Durchgangsbohrungen 24, 34 der Substratschichten 20, 30 mit Durchbrüchen 44 versehen, wobei deren Lichte Weite d kleiner ist als der Durchmesser D der Durchgangsbohrungen 24, 34 in den Substratschichten 20, 30. Günstigerweise werden dadurch die drahtgebundenen Bauteile 70 in der Zwischenschicht 40 kraft- oder reibschlüssig gehalten.

Eine solche erfindungsgemäße Leiterplatte 10 kann mit großem Vorteil zur rationellen und kostengünstigen Herstellung einer mischbestückten Leiterplatte 10 verwendet werden.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

**Bezugszeichenliste**

| | | | |
|---|---|---|---|
| A | Außendurchmesser | 31 | Leiterbahnen |
| d | lichte Weite | 32 | Leitschicht |
| D | Durchmesser | 34 | Durchgangsbohrung |
| L | Lotpaste | 35 | Innenwand |
| M | Metallisierungslösung | | |
| O | Bestückungsseite | 40 | Zwischenschicht |
| o' | abgewandte Seite | 40' | weitere Zwischenschicht |
| U | Bestückungsseite | 41 | Teil |
| u' | abgewandte Seite | 41' | Teil |
| | | 44 | Durchbruch |
| 10 | Leiterplatte | 44' | Durchbruch |
| | | | |
| 20 | erste Substratschicht | 50 | Metallisierung |
| 200 | weitere Substratschicht | | |
| 21 | Leiterbahn | 60 | Verbindungsschicht |
| 22 | Leitschicht | | |
| 23 | Signalebene | 70 | drahtgebundenes Bauteil |
| 23' | Signalebene | 71 | Anschlusspin |
| 23" | Signalebene | 72 | Ende |
| 24 | Durchgangsbohrung | 80 | SMD-Bauteil |
| 240 | Durchgangsbohrung | | |
| 25 | Innenwand | 90 | Ausnehmungen |
| 30 | zweite Substratschicht | | |

## Patentansprüche

1. Leiterplatte (10) zur Bestückung mit oberflächenmontierbaren - SMD - und mit drahtgebundenen Bauteilen (80, 70)
▪ mit einer ersten Substratschicht (20), die auf ihrer Bestückungsseite (O) eine Leiterbahnen (21) aufweisende Leitschicht (22) trägt und mit Durchgangsbohrungen (24) versehen ist,
▪ mit einer zweiten Substratschicht (30), die eine Bestückungsseite (U) aufweist und die mit Durchgangsbohrungen (34) versehen ist,
▪ wobei die Durchgangsbohrungen (24, 34) eine Metallisierung (50) aufweisen,
▪ mit einer Zwischenschicht (40), die zwischen den Substratschichten (20, 30) angeordnet ist,
wobei
▪ die Durchgangsbohrungen (24, 34) in den Bestückungsseiten (O, U) der Substratschichten (20, 30) ausgebildet sind und kongruent übereinander liegen,
▪ die metallisierten Durchgangsbohrungen (24, 34) elektrisch leitend mit den Leiterbahnen (21) der Leitschicht (22) der ersten Substratschicht (20) verbunden sind,
▪ die Zwischenschicht (40) zumindest abschnittsweise in eine durch die Durchgangsbohrungen (24, 34) gebildete Bohrung hineinragt,
▪ die Zwischenschicht (40) aus einem elektrisch leitfähigen Material besteht, wobei
▪ die Zwischenschicht (40) durch Strukturierung als mittlere Signalebene mit Leiterbahnen ausgebildet ist.

2. Leiterplatte nach Anspruch 1, **dadurch gekennzeichnet, dass** die Zwischenschicht (40) im Bereich der Durchgangsbohrungen (24, 34) der Substratschichten (20, 30) mit Durchbrüchen (44) versehen ist, wobei die Lichte Weite (d) der Durchgangsbohrungen (44) in der Zwischenschicht (40) kleiner ist als der Durchmesser (D) der Durchgangsbohrungen (24, 34) in den Substratschichten (20, 30).

3. Leiterplatte nach einem der Ansprüche 1 oder 2, **dadurch gekennzeichnet, dass** die an der Bestückungsseite (O) der ersten Substratschicht (20) angeordneten SMDs (80) mit den an der Bestückungsseite (U) der zweiten Substratschicht (30) angeordneten drahtgebundenen Bauelementen (70) einen gemeinsamen Schaltkreis bilden.

4. Leiterplatte nach einem der Ansprüche 1 bis 3, **dadurch gekennzeichnet, dass** die Substratschichten (20, 30) und die Zwischenschicht (40) form-, kraft- und/oder stoffschlüssig miteinander verbunden sind.

5. Leiterplatte nach einem der Ansprüche 1 bis 4, **dadurch gekennzeichnet, dass** zwischen der Zwischenschicht (40) und jeder Substratschicht (20, 30) eine Verbindungsschicht (60) angeordnet ist, wobei die Durchgangsbohrungen (24, 34) der Substratschichten (20, 30) in den Verbindungsschichten (60) fortgesetzt sind.

6. Leiterplatte nach einem der Ansprüche 1 bis 5, **dadurch gekennzeichnet, dass** die zweite Substratschicht (30) auf ihrer Bestückungsseite (U) eine Leiterbahnen (31) aufweisende Leitschicht (32) trägt.

7. Leiterplatte nach einem der Ansprüche 1 bis 6, **dadurch gekennzeichnet, dass** zwischen den Substratschichten (20, 30) wenigstens eine weitere Substratschicht (200) und/oder wenigstens eine weitere Zwischenschicht (40') angeordnet ist.

8. Leiterplatte nach einem der Ansprüche 1 bis 7, **dadurch gekennzeichnet, dass** die Metallisierung (50) der Durchgangsbohrungen (24, 34) die Zwischenschichten (40, 40') mit den Leiterschichten (22) durch die Substratschichten (20, 30) hindurch elektrisch leitend verbindet.

9. Verfahren zur Herstellung einer Leiterplatte nach einem der Ansprüche 1 bis 8 umfassend die Schritte
▪ Bereitstellung einer ersten und einer zweiten Substratschicht (20, 30);
▪ Einbringen von Durchgangsbohrungen (24, 34) in die Substratschichten (20, 30);
▪ Auflegen einer Zwischenschicht aus einem elektrisch leitendem Material auf die der Bestückungsseite (O) abgewandten Seite (o') der erste Substratschicht (20);
▪ Auflegen der zweiten Substratschicht (30) mit ihrer Bestückungsseite (U) abgewandten Seite (u') auf die Zwischenschicht (40);
▪ form-, kraft- und/oder stoffschlüssiges Verbinden aller Schichten miteinander,
▪ Einbringen von Durchbrüchen (44) in die Zwischenschicht (40) im Bereich der Durchgangsbohrungen (24, 34);
▪ Reinigung der Durchgangsbohrungen (24, 34);
▪ Metallisierung der Durchgangsbohrungen (24, 34);
▪ Strukturierung der Bestückungsseiten (U, O) der Leiterplatte (10), wobei
▪ die Zwischenschicht (40) vor dem Auflegen der zweiten Substratschicht (30) bzw. der zweiten Verbindungsschicht (60) zu einer mittleren Signalebene mit Leiterbahnen strukturiert wird.

10. Verfahren nach Anspruch 9, **dadurch gekennzeichnet, dass** zwischen der ersten Substratschicht (20) und der Zwischenschicht (40) eine erste Verbindungsschicht (60) angeordnet wird und/oder dass zwischen der Zwischenschicht (40) und der zweiten Substratschicht (30) eine zweite Verbindungsschicht (60) angeordnet wird, wobei in jeder Verbindungsschicht (60) Bohrungen (64) eingebracht werden, die beim Aufeinanderlegen der Verbindungs- und Substratschichten (60, 20, 30) deckungsgleich mit den Durchgangsbohrungen (24, 34) der Substratschichten (20, 30) angeordnet sind.

11. Verfahren nach einem der Ansprüche 9 oder 10, **dadurch gekennzeichnet, dass** das Reinigen und Metallisieren der Durchgangsbohrungen (24, 34) die Schritte umfasst
▪ Reinigen der Leiterplatte (10) mittels Rückätzlösung;
▪ Einbringung von Ausnehmungen (90) an den Stellen, an denen die Zwischenschicht (40) in die Durchgangsbohrungen eintritt, mittels Rückätzlösung;
▪ Eintauchen der Leiterplatte (10) in eine Metallisierungslösung (M);
▪ Einbringen der Leiterplatte (10) in ein Hochvakuum.

12. Verfahren nach einem der Ansprüche 9 bis 11, **dadurch gekennzeichnet, dass** die Zwischenschicht (40), die erste Verbindungsschicht (60) und die erste Substratschicht (20) nach dem Auflegen der Zwischenschicht (40) auf die erste Verbindungsschicht (60) miteinander verpresst werden.

13. Verwendung einer Leiterplatte (10) nach mindestens einem der Ansprüche 1 bis 8 zur Herstellung einer mischbestückten Leiterplatte.

## Claims

1. Printed circuit board (10) for assembly with surface-mounted - SMD - and with wired components (80, 70)
▪ having a first substrate layer (20), which carries on its component side (O) a conducting layer (22), having conducting paths (21), and is provided with through-holes (24),
▪ having a second substrate layer (30), which has a component side (U) and is provided with through-holes (34),
▪ wherein the through-holes (24, 34) have a metallic coating (50),
▪ having an intermediate layer (40), which is disposed between the substrate layers (20, 30),
wherein
▪ the through-holes (24, 34) are configured in the component sides (O, U) of the substrate layers (20, 30) and lie congruently one above the other,
▪ the metal-coated through-holes (24, 34) are electrically connected with the conducting paths (21) of the conducting layer (22) of the first substrate layer (20),
▪ the intermediate layer (40) extends at least in sections into a hole formed by the through-holes (24, 34),
▪ the intermediate layer (40) consists of an electrically conductive material, wherein
▪ the intermediate layer (40) is configured through structuring as central signal plane with conducting paths.

2. Printed circuit board according to claim 1, **characterised in that** the intermediate layer (40) is provided with openings (44) in the region of the through-holes (24, 34) of the substrate layers (20, 30), wherein the clear width (d) of the through-holes (44) in the intermediate layer (40) is smaller than the diameter (D) of the through-holes (24, 34) in the substrate layers (20, 30).

3. Printed circuit board according to any one of claims 1 or 2, **characterised in that** the SMDs (80) disposed on the component side (O) of the first substrate layer (20) form a common switching circuit with the wired structural elements (70) disposed on the component side (U) of the second substrate layer (30).

4. Printed circuit board according to any one of claims 1 to 3, **characterised in that** the substrate layers (20, 30) and the intermediate layer (40) are connected together by means of form-fitting, force-fitting and/or bonding.

5. Printed circuit board according to any one of claims 1 to 4, **characterised in that** a connecting layer (60) is disposed between the intermediate layer (40) and each substrate layer (20, 30), wherein the through-holes (24, 34) of the substrate layers (20, 30) are continued in the connecting layers (60).

6. Printed circuit board according to any one of claims 1 to 5, **characterised in that** the second substrate layer (30) carries a conducting layer (32), having conducting paths (31), on its component side (U).

7. Printed circuit board according to any one of claims 1 to 6, **characterised in that** at least one further substrate layer (200) and/or at least one further intermediate layer (40') is disposed between the substrate layers (20, 30).

8. Printed circuit board according to any one of claims 1 to 7, **characterised in that** the metallic coating (50) of the through-holes (24, 34) connects the intermediate layers (40, 40') in an electrically conductive manner with the conducting layers (22) through the substrate layers (20, 30).

9. Method for manufacturing a printed circuit board according to any one of claims 1 to 8 comprising the steps
▪ provision of a first and a second substrate layer (20, 30);
▪ introduction of through-holes (24, 34) into the substrate layers (20, 30);
▪ placing of an intermediate layer of an electrically conducting material onto the side (o') of the first substrate layer (20) facing away from the component side (O);
▪ placing of the second substrate layer (30) with its side (u') facing away from component side (U) onto the intermediate layer (40);
▪ interconnecting of all layers by means of form-fitting, force-fitting and/or bonding,
▪ introduction of openings (44) into the intermediate layer (40) in the region of the through-holes (24, 34);
▪ cleaning of the through-holes (24, 34);
▪ metallic coating of the through-holes (24, 34);
▪ structuring of the component sides (U, O) of the printed circuit board (10), wherein
▪ the intermediate layer (40) is structured into a central signal plane with conducting paths before the placing of the second substrate layer (30) or of the second connecting layer (60).

10. Method according to claim 9, **characterised in that** a first connecting layer (60) is disposed between the first substrate layer (20) and the intermediate layer (40) and/or that a second connecting layer (60) is disposed between the intermediate layer (40) and the second substrate layer (30), wherein holes (64) are introduced in each connecting layer (60), said holes being disposed congruently with the through-holes (24, 34) of the substrate layers (20, 30), when the connecting layers and substrate layers (60, 20, 30) are placed one on top of the other.

11. Method according to any one of claims 9 or 10, **characterised in that** the cleaning and the metal-coating of the through-holes (24, 34) comprises the steps
▪ cleaning of the printed circuit board (10) by means of etch-back solution;
▪ introduction of recesses (90) - by means of etch-back solution - in the places, where the intermediate layer (40) enters the through-holes;
▪ immersion of the printed circuit board (10) into a metallizing solution (M);
▪ introduction of the printed circuit board (10) into a high vacuum.

12. Method according to any one of claims 9 to 11, **characterised in that** the intermediate layer (40), the first connecting layer (60) and the first substrate layer (20) are pressed together after the placing of the intermediate layer (40) onto the first connecting layer (60).

13. Use of a printed circuit board (10) according to at least one of claims 1 to 8 for manufacturing a mixed printed circuit board.

## Revendications

1. Carte de circuits imprimés (10) destinée à être équipée avec des composants montés en surface - CMS - et avec des composants câblés (80, 70)
- avec une première couche de substrat (20), qui porte sur son côté équipé (O) une couche conductrice (22) comportant des pistes conductrices (21) et qui est munie de trous traversants (24),
- avec une deuxième couche conductrice (30), qui comporte un côté équipé (U) et qui est munie de trous traversants (34),
- lesquels trous traversants (24, 34) comportent une métallisation (50),
- avec une couche intermédiaire (40), qui est agencée entre les couches de substrat (20, 30),
dans laquelle
- les trous traversants (24, 34) sont réalisés dans les côtés équipés (O, U) des couches de substrat (20, 30) et se trouvent les uns au-dessus des autres de manière congruente,
- les trous traversants (24, 34) métallisés sont reliés de manière électriquement conductrice aux pistes conductrices (21) de la couche conductrice (22) de la première couche de substrat (20),
- la couche intermédiaire (40) pénètre au moins par endroits dans un trou formé par les trous traversants (24, 34),
- la couche intermédiaire (40) est en un matériau électriquement conducteur,
- la couche intermédiaire (40) est réalisée par structuration comme plan de signaux médian avec des pistes conductrices.

2. Carte de circuits imprimés selon la revendication 1, **caractérisée en ce que** la couche intermédiaire (40) est munie de passages (44) dans la zone des trous traversants (24, 34) des couches de substrat (20, 30), la largeur libre (d) des trous traversants (44) dans la couche intermédiaire (40) étant plus petite que le diamètre (D) des trous traversants (24, 34) dans les couches de substrat (20, 30).

3. Carte de circuits imprimés selon l'une quelconque des revendications 1 ou 2, **caractérisée en ce que** les CMS (80) agencés sur le côté équipé (O) de la première couche de substrat (20) forment avec les composants câblés (70) agencés sur le côté équipé (U) de la deuxième couche de substrat (30) un circuit intégré commun.

4. Carte de circuits imprimés selon l'une quelconque des revendications 1 à 3, **caractérisée en ce que** les couches de substrat (20, 30) et la couche intermédiaire (40) sont assemblées l'une à l'autre par concordance de forme, par force ou par liaison de matière.

5. Carte de circuits imprimés selon l'une quelconque des revendications 1 à 4, **caractérisée en ce qu'**une couche de liaison (60) est agencée entre la couche intermédiaire (40) et chaque couche de substrat (20, 30), les trous traversants (24, 34) des couches de substrat (20, 30) se poursuivant dans les couches de liaison (60).

6. Carte de circuits imprimés selon l'une quelconque des revendications 1 à 5, **caractérisée en ce que** la deuxième couche de substrat (30) porte sur son côté équipé (U) une couche conductrice (32) comportant des pistes conductrices (31).

7. Carte de circuits imprimés selon l'une quelconque des revendications 1 à 6, **caractérisée en ce qu'**au moins une autre couche de substrat (200) et/ou au moins une autre couche intermédiaire (40') sont agencées entre les couches de substrat (20, 30).

8. Carte de circuits imprimés selon l'une quelconque des revendications 1 à 7, **caractérisée en ce que** la métallisation (50) des trous traversants (24, 34) relie de manière électriquement conductrice les couches intermédiaires (40, 40') aux couches conductrices (22) à travers les couches de substrat (20, 30).

9. Procédé de fabrication d'une carte de circuits imprimés selon l'une quelconque des revendications 1 à 8, comprenant les étapes
- préparation d'une première et d'une deuxième couche de substrat (20, 30) ;
- fabrication de trous traversants (24, 34) dans les couches de substrat (20, 30) ;
- pose d'une couche intermédiaire en un matériau électriquement conducteur sur le côté (o'), opposé au côté équipé (O), de la première couche de substrat (20) ;
- pose de la deuxième couche de substrat (30) avec son côté (u') opposé au côté équipé (U) sur la couche intermédiaire (40) ;
- assemblage par concordance de forme, par force et/ou par liaison de matière de toutes les couches les unes aux autres ;
- fabrication de passages (44) dans la couche intermédiaire (40) dans la zone des trous traversants (24, 34) ;
- nettoyage des trous traversants (24, 34) ;
- métallisation des trous traversants (24, 34) ;
- structuration des côtés équipés (U, O) de la carte de circuits imprimés (10),
- la couche intermédiaire (40) étant structurée avant la pose de la deuxième couche de substrat (30) ou de la deuxième couche de liaison (60) en un plan de signaux médian avec pistes conductrices.

10. Procédé selon la revendication 9, **caractérisé en ce qu'**une première couche de liaison (60) est agencée entre la première couche de substrat (20) et la couche intermédiaire (40) et/ou **en ce qu'**une deuxième couche de liaison (60) est agencée entre la couche intermédiaire (40) et la deuxième couche de substrat (30), des trous (64) étant fabriqués dans chaque couche de liaison (60), lesquels sont agencés de manière à coïncider avec les trous traversants (24, 34) des couches de substrat (20, 30) lorsque les couches de liaison et de substrat (60, 20, 30) sont posées les unes sur les autres.

11. Procédé selon l'une quelconque des revendications 9 ou 10, **caractérisé en ce que** le nettoyage et la métallisation des trous traversants (24, 34) comprennent les étapes :
- nettoyage de la carte de circuits imprimés (10) avec une solution de gravure en retrait ;
- fabrication d'évidements (90) aux endroits où la couche intermédiaire (40) entre dans les trous traversants au moyen d'une solution de gravure en retrait ;
- plongée de la carte de circuits imprimés (10) dans une solution de métallisation (M) ;
- placement de la carte de circuits imprimés (10) dans un vide poussé.

12. Procédé selon l'une quelconque des revendications 9 à 11, **caractérisé en ce que** la couche intermédiaire (40), la première couche de liaison (60) et la première couche de substrat (20) sont pressées ensemble après la pose de la couche intermédiaire (40) sur la première couche de liaison (60).

13. Utilisation d'une carte de circuits imprimés (10) selon l'une quelconque des revendications 1 à 8 pour la fabrication d'une carte de circuits imprimés à équipement mixte.
